# EUROPEAN PATENT APPLICATION

(11) **EP 4 383 328 A1**
(43) Date of publication of application: **12.06.2024**
(21) Application number: 23201733.5
(22) Date of filing: 05.10.2023
(51) Int. Cl.: H01L 23/525

(54) **ONE-TIME PROGRAMMABLE FUSE USING PN JUNCTION OVER GATE METAL LAYER, AND RELATED METHOD**

(30) Priority: 05.12.2022 US 202218061538
(71) Applicant: GlobalFoundries U.S. Inc., Malta, NY 12020 (US)
(72) Inventor: Mulfinger, George Robert, Malta, 12020 (US); Mala, Selina A., Malta, 12020 (US); Pandey, Shesh Mani, Malta, 12020 (US); Rosenfeld, Adam S., Santa Rosa, 95405 (US); Bhuyian, Md Nasir Uddin, Malta, 12020 (US)
(74) Representative: Grünecker Patent- und Rechtsanwälte PartG mbB

(57) **Abstract**

A one-time programmable (OTP) fuse includes a trench isolation; a gate metal layer over the trench isolation; and a PN junction over the gate metal layer. More particularly, the OTP fuse may include a first terminal including a highly doped n-type polysilicon layer over the trench isolation, and a second terminal including a highly doped p-type polysilicon layer over the trench isolation. The highly doped n-type polysilicon layer contacts the highly doped p-type polysilicon layer, creating a PN junction and a fuse link defined in a portion of the gate metal layer between the trench isolation and the PN junction. The gate metal layer has a uniform thickness that allows better dimension control of the fuse link to reduce fuse programming current variability.

## Description

### BACKGROUND

The present disclosure relates to semiconductor structures and, more particularly, to a one-time programmable fuse using a PN junction over a gate metal layer, and a related method of forming the same.

Programmable devices, such as electronic fuses (e-fuses), are widely used elements found in various programmable integrated circuits (IC), such as redundancy circuits of dynamic random-access memories and static random-access memories, programmable logic devices, input/output circuits, built-in self-repair systems, and chip identification circuits. An e-fuse includes a pair of terminals and a narrow fuse link connecting the terminals, e.g., silicide in a front-end-of-line layer of an IC chip. When manufactured, an e-fuse is initially intact between the two terminals. E-fuses can be irreversibly programmed by passing an electric current through the fuse link to cause electromigration of the fuse link material. Once sufficient material has migrated, the fuse link is programmed (i.e., higher resistance/blown), stopping/resisting current from passing through the e-fuse. The size of the fuse link, at least in part, defines the amount of current necessary to program the e-fuse - narrower and thinner fuse links require less current to program them. Current e-fuses use silicide on active regions, i.e., silicide on silicon or polysilicon, in the front-end-of-line (FEOL) layer of an IC. One challenge presented by these e-fuses is controlling the dimensions, such as active width and thickness, of the silicide fuse link. The variability in the fuse link dimensions makes forming an e-fuse with a desired programing current difficult.

### SUMMARY

All aspects, examples and features mentioned below can be combined in any technically possible way.

An aspect of the disclosure provides a one-time programmable (OTP) fuse, comprising: a trench isolation; a gate metal layer over the trench isolation; and a PN junction over the gate metal layer.

An aspect of the disclosure provides a one-time programmable (OTP) fuse, comprising: a trench isolation in a substrate; a first terminal including a highly doped n-type polysilicon layer over the trench isolation; a second terminal including a highly doped p-type polysilicon layer over the trench isolation, wherein the highly doped n-type polysilicon layer contacts the highly doped p-type polysilicon layer, creating a PN junction; and a fuse link defined in a portion of a gate metal layer between the trench isolation and the PN junction.

An aspect of the disclosure provides a method of forming a one-time programmable (OTP) fuse, the method comprising: forming a gate metal stack including a trench isolation over a substrate, a gate metal layer over the trench isolation and a polysilicon layer over the trench isolation; forming a first terminal by doping a first portion of the polysilicon layer with an n-type dopant, creating a highly doped n-type polysilicon layer over the gate metal layer; and forming a second terminal by doping a second portion of the polysilicon layer with a p-type dopant, creating a highly doped p-type polysilicon layer over the gate metal layer, wherein the highly doped n-type polysilicon layer contacts the highly doped p-type polysilicon layer, creating a PN junction and a fuse link in the gate metal layer under the PN junction.

Two or more aspects described in this disclosure, including those described in this summary section, may be combined to form implementations not specifically described herein. The details of one or more implementations are set forth in the accompanying drawings and the description below. Other features, objects and advantages will be apparent from the description and drawings, and from the claims.

### BRIEF DESCRIPTION OF THE DRAWINGS

The embodiments of this disclosure will be described in detail, with reference to the following figures, wherein like designations denote like elements, and wherein:
FIG. 1 shows a cross-sectional view of a one-time programmable (OTP) fuse, according to embodiments of the disclosure;
FIG. 2-4 show cross-sectional views of a method of forming the OTP fuse, according to embodiments of the disclosure; and
FIG. 5 shows a cross-sectional view of the OTP fuse of FIG. 1 in a programmed condition, according to embodiments of the disclosure.

It is noted that the drawings of the disclosure are not necessarily to scale. The drawings are intended to depict only typical aspects of the disclosure, and therefore should not be considered as limiting the scope of the disclosure. In the drawings, like numbering represents like elements between the drawings.

### DETAILED DESCRIPTION

In the following description, reference is made to the accompanying drawings that form a part thereof, and in which is shown by way of illustration specific illustrative embodiments in which the present teachings may be practiced. These embodiments are described in sufficient detail to enable those skilled in the art to practice the present teachings, and it is to be understood that other embodiments may be used and that changes may be made without departing from the scope of the present teachings. The following description is, therefore, merely illustrative.

It will be understood that when an element such as a layer, region, or substrate is referred to as being "on" or "over" another element, it may be directly on the other element or intervening elements may also be present. In contrast, when an element is referred to as being "directly on" or "directly over" another element, there may be no intervening elements present. It will also be understood that when an element is referred to as being "connected" or "coupled" to another element, it may be directly connected or coupled to the other element or intervening elements may be present. In contrast, when an element is referred to as being "directly connected" or "directly coupled" to another element, there are no intervening elements present.

Reference in the specification to "one embodiment" or "an embodiment" of the present disclosure, as well as other variations thereof, means that a particular feature, structure, characteristic, and so forth described in connection with the embodiment is included in at least one embodiment of the present disclosure. Thus, the phrases "in one embodiment" or "in an embodiment," as well as any other variations appearing in various places throughout the specification are not necessarily all referring to the same embodiment. It is to be appreciated that the use of any of the following "/," "and/or," and "at least one of," for example, in the cases of "A/B," "A and/or B" and "at least one of A and B," is intended to encompass the selection of the first listed option (a) only, or the selection of the second listed option (B) only, or the selection of both options (A and B). As a further example, in the cases of "A, B, and/or C" and "at least one of A, B, and C," such phrasing is intended to encompass the first listed option (A) only, or the selection of the second listed option (B) only, or the selection of the third listed option (C) only, or the selection of the first and the second listed options (A and B), or the selection of the first and third listed options (A and C) only, or the selection of the second and third listed options (B and C) only, or the selection of all three options (A and B and C). This may be extended, as readily apparent by one of ordinary skill in the art, for as many items listed.

Embodiments of the disclosure include a one-time programmable (OTP) fuse and a related method. The OTP fuse includes a trench isolation; a gate metal layer over the trench isolation; and a PN junction over the gate metal layer. More particularly, the OTP fuse may include a first terminal including a highly doped n-type polysilicon layer over the trench isolation, and a second terminal including a highly doped p-type polysilicon layer over the trench isolation. The highly doped n-type polysilicon layer contacts the highly doped p-type polysilicon layer, creating a PN junction and a fuse link defined in a portion of the gate metal layer between the trench isolation and the PN junction. The gate metal layer has a thin and uniform thickness that allows better dimension control of the fuse link to reduce fuse programming current variability compared to conventional silicide fuse links. The OTP fuse thus has improved e-fuse programming efficiency and production margins.

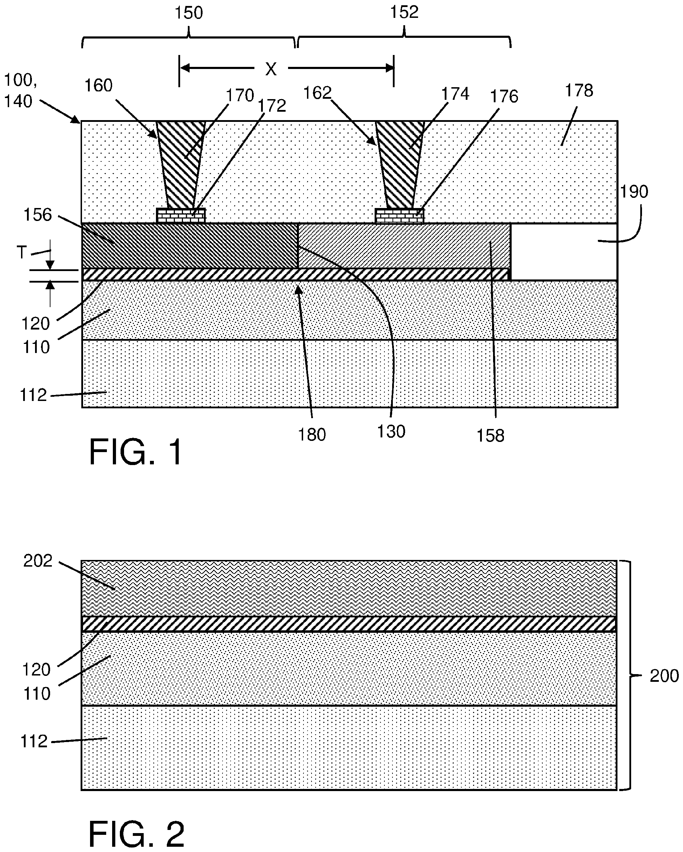

FIG. 1 shows a cross-sectional view of a one-time programmable fuse 100, according to embodiments of the disclosure. One-time programmable fuse 100 (hereafter "fuse 100") may include a trench isolation 110, a gate metal layer 120 over trench isolation 110 and a PN junction 130 over gate metal layer 120. Fuse 100 may be used in an IC chip 140 in any now known or later developed fashion.

Trench isolation 110 may be formed in a substrate 112. Substrate 112 may include any now known or later developed semiconductor substrate. Substrate 112 may take any now known or later developed form, e.g., bulk, fin, etc. In one embodiment, substrate 112 may include a dopant, such as a p-type dopant. Substrate 112 may be electrically coupled to ground. Trench isolation 110 may include any currently-known or later developed substance for providing electrical insulation, and as examples may include: silicon nitride (Si₃N₄), silicon oxide (SiO₂), fluorinated SiO₂ (FSG), hydrogenated silicon oxycarbide (SiCOH), porous SiCOH, borophospho-silicate glass (BPSG), silsesquioxanes, carbon (C) doped oxides (i.e., organosilicates) that include atoms of silicon (Si), carbon (C), oxygen (O), and/or hydrogen (H), thermosetting polyarylene ethers, a spin-on silicon-carbon containing polymer material, near frictionless carbon (NFC), or layers thereof. While trench isolation 110 is shown as a layer in the drawings, it is understood that it may be provided with any length (side-to-side on page) in a trench within substrate 112.

Gate metal layer 120 is referred to as a "gate metal" because the layer also forms part of transistors (not shown) in other regions of IC chip 140. Gate metal layer 120 may include a work function metal typically used in a gate metal stack for transistors (and perhaps other structure) in IC chip 140. Gate metal layer 120 may include various metals depending on whether for an n-type field effect transistor (NFET) or p-type FET (PFET) device, but may include, for example: aluminum (Al), zinc (Zn), indium (In), tin (Sn), tantalum (Ta), tantalum nitride (TaN), tantalum carbide (TaC), titanium (Ti), titanium nitride (TiN), titanium carbide (TiC), TiAlC, TiAl, tungsten (W), tungsten nitride (WN), tungsten carbide (WC), polycrystalline silicon (poly-Si), and/or combinations thereof. In one embodiment, gate metal layer 120 includes titanium nitride (TiN).

Fuse 100 also includes a first terminal 150 and a second terminal 152. PN junction 130 is defined by first terminal 150 including a highly doped n-type polysilicon layer 156 (hereafter "n-type layer 156"), and second terminal 152 including a highly doped p-type polysilicon layer 158 (hereafter "p-type layer 158"). The term "PN junction" 130 refers to two adjacent materials having different types of conductivity (i.e., n-type and p-type), which may be induced through dopants within the adjacent material(s). A PN junction, when formed in IC chip 140, may operate as a diode. A diode is a two-terminal element which behaves differently from conductive or insulative materials between two points of electrical contact. Specifically, a diode provides high conductivity from one contact to the other in one direction (i.e., the "forward" direction), but provides little to no conductivity in the opposite direction (i.e., the "reverse" direction). In the case of PN junction 130, the orientation of a diode's forward and reverse directions may be contingent on the type and magnitude of bias applied to the material composition of one or both terminals (described herein), which affect the size of the potential barrier. The potential barrier will be formed along the interface between the two semiconductor materials. In fuse 100, n-type layer 156 contacts p-type layer 158, creating PN junction 130. N-type layer 156 and p-type layer 158 are over trench isolation 110. As used herein, "highly doped" as it applies to n-type layer 156 means a dopant concentration of in the range of 1E19 to 1E21 atoms per cubic centimeter (atoms/cm³), and as it applies to p-type layer 158 also means a dopant concentration of between 1E19 to 1E21 atoms/cm³. For a silicon substrate 112, n-type dopants may include, for example, a Group III dopant, such as boron (B) or indium (In); and p-type dopants may include, for example, a Group V dopant, such as arsenic (As), phosphorus (P) or antimony (Sb).

First terminal 150 may also include a first contact 160 over n-type layer 156, and second terminal 152 may also include a second contact 162 over p-type layer 158. First contact 160 may include a first conductive body 170 and a first silicide layer 172 between first conductive body 170 and n-type layer 156. Similarly, second contact 162 may include a second conductive body 174 and a second silicide layer 176 between second conductive body 174 and p-type layer 158. Each conductive body 170, 174 may include any now known or later developed contact (via) structure including a refractory metal liner and a conductive inner body. The refractory metal liner material can be any material appropriate to stop electromigration of the material of a conductive inner body to be formed therein. For example, the liner may include ruthenium (Ru), tantalum (Ta), titanium (Ti), tungsten (W), iridium (Ir), rhodium (Rh) and platinum (Pt), etc., or mixtures of thereof. The conductive inner body may include any conductive material appropriate for contacts, such as but not limited to: copper (Cu), tungsten (W), among others. Silicide layers 172, 176 may include any now known or later developed silicide, e.g., nickel silicide, cobalt silicide, titanium silicide, among others. Contacts 160, 162 and silicide layers 172, 176 may be in any appropriate interlayer dielectric (ILD) layer 178, e.g., of silicon oxide or other appropriate ILD material.

Fuse 100 also includes a fuse link 180, which is defined by a portion of gate metal layer 120 below PN junction 130. More particularly, fuse link 180 is defined by a portion of gate metal layer 120 between trench isolation 110 and PN junction 130. Since gate metal layer 120 has a thin and uniform thickness T along a length thereof (sideways on page), defining a programming current for fuse 100 is easier than with conventional silicide fuse links. That is, gate metal layer 120 allows better dimension control of fuse link 180 to reduce fuse programming current variability compared to conventional silicide fuse links. Fuse 100 thus has improved e-fuse programming efficiency and production margins.

Fuse 100 also may include an e-fuse driver 190, i.e., circuitry, controlling application of a programming current to terminals 150, 152 through electrical interconnects (not shown). E-fuse driver 190 may include any now known or later developed circuitry for controlling application of current to terminals 150, 152. As illustrated, e-fuse driver 190 may be adjacent gate metal layer 120, and may have devices, e.g., transistors, formed in other regions of gate metal layer 120 and/or the polysilicon layer thereover.

FIGS. 2-4 show cross-sectional views of a method of forming OTP fuse 100, according to embodiments of the disclosure.

FIG. 2 shows forming a gate metal stack 200 including trench isolation 110 over substrate 112, gate metal layer 120 over trench isolation 110 and a polysilicon layer 202 over trench isolation 110. Gate stack 200 can be formed using any now known or later developed semiconductor fabrication techniques. For example, trench isolation 110 may include a trench (not shown) etched into semiconductor substrate 112 and filled with an insulating material such as oxide, to isolate one region of substrate 112 from an adjacent region of the substrate. Trench isolation 110 may include any of the previously listed materials. Trench isolation 110 may be provided as a shallow trench isolation (STI) or a deep trench isolation (DTI).

Gate metal layer 120 may be deposited using any appropriate deposition technique for the material use, e.g., chemical vapor deposition for titanium nitride (TiN). As noted, gate metal layer 120 may include various metals depending on whether for an NFET or PFET device, but may include, for example: aluminum (Al), zinc (Zn), indium (In), tin (Sn), tantalum (Ta), tantalum nitride (TaN), tantalum carbide (TaC), titanium (Ti), titanium nitride (TiN), titanium carbide (TiC), TiAlC, TiAl, tungsten (W), tungsten nitride (WN), tungsten carbide (WC), polycrystalline silicon (poly-Si), and/or combinations thereof. In any event, gate metal layer 120 has a relatively thin and uniform thickness T. For example, it may have a thickness in range of 5 to 10 nanometers (nm) with a deviation of +/- 0.2 to 1.0 Angstroms. Polysilicon layer 202 may be deposited using any appropriate deposition technique for the material use, e.g., epitaxial growth.

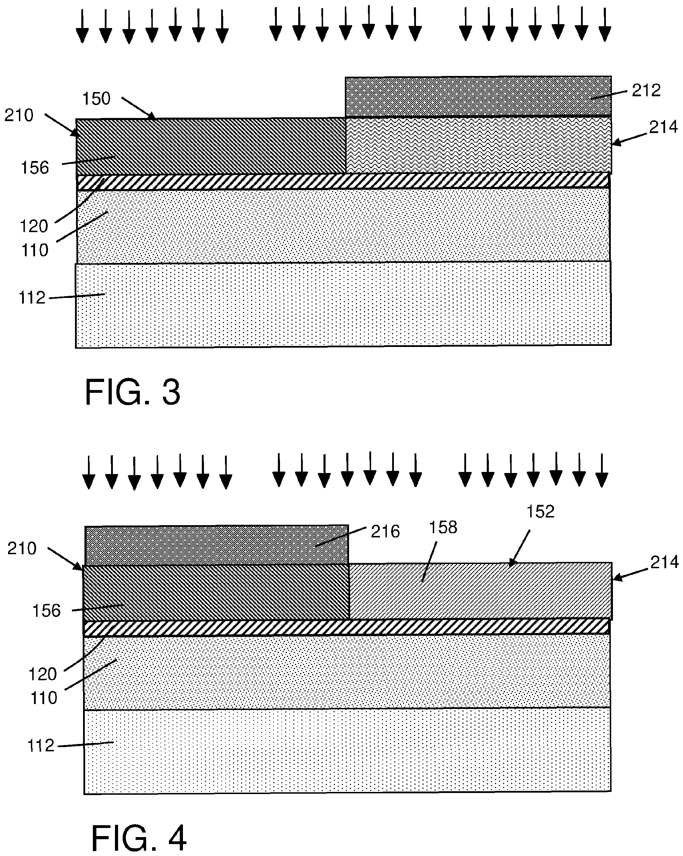

FIG. 3 shows forming (part of) first terminal 150 by doping a first portion 210 of polysilicon layer 202 (FIG. 2) with an n-type dopant, creating highly doped n-type polysilicon layer 156 over trench isolation 110. As noted, n-type dopants may include, for example, a Group III dopant, such as boron (B) or indium (In). This doping step may be performed using, for example, ion implantation (arrows) with a mask 212 covering a different, second portion 214 of polysilicon layer 202 (FIG. 2). In one non-limiting example, a dosage in a range of 5E13 to 5E15 atoms per square centimeter (atoms/cm²) may be used, resulting in a dopant concentration of in a range of 1E19 to 1E21 atoms/cm³ for n-type layer 156. Mask 212 may include a layer of material which is applied over an underlying layer of material, and patterned to have openings, so that the underlying layer can be processed where there are openings. Common masking materials are photoresist (resist) and nitride. Nitride is usually considered to be a "hard mask." Mask may include a developable organic planarization layer (OPL) on the layer to be processed, a developable anti-reflective coating (ARC) layer on the developable OPL, and a photoresist mask layer on the developable ARC layer. After forming n-type layer 156, mask 212 may be removed using any known removal process appropriate for the mask material, e.g., a wet etch for hard nitride mask or an ashing process (oxygen dry strip process) for a soft resist-based mask.

FIG. 4 shows forming (part of) a second terminal 152 by doping second portion 214 of polysilicon layer 202 (FIG. 2) with a p-type dopant, creating highly doped p-type polysilicon layer 158 over gate metal layer 120. As noted, p-type dopants may include, for example, a Group V dopant, such as arsenic (As), phosphorus (P) or antimony (Sb). This doping step may be performed using, for example, ion implantation (arrows) with a mask 216 covering first portion 210 of polysilicon layer 202 (FIG. 2). In one non-limiting example, a dosage in a range of 5E13 to 5E15 atoms/cm² may be used, resulting in a dopant concentration of in a range of 1E19 to 1E21 atoms/cm³ for p-type layer 158. Mask 216 may include the same material as listed for mask 212 (FIG. 3). After forming p-type layer 158, mask 216 may be removed using any known removal process appropriate for the mask material, e.g., a wet etch for hard nitride mask or an ashing process (oxygen dry strip process) for a soft resist-based mask. As noted, n-type layer 156 contacts p-type layer 158, creating PN junction 130 and fuse link 180 in gate metal layer 120 under PN junction 130.

Returning to FIG. 1, forming first terminal 150 may further include forming first contact 160 over n-type layer 156, and forming second terminal 152 may further include forming second contact 162 over p-type layer 158. As noted, first contact 160 may include first conductive body 170 and first silicide layer 172 between first conductive body 170 and n-type layer 156. Similarly, second contact 162 may include second conductive body 174 and second silicide layer 176 between second conductive body 174 and p-type layer 158. Contacts 160, 162 may be formed within predetermined portions of ILD layer 178, previously deposited over n-type layer 156 and p-type layer 158, among other structure. Contacts 160, 162 may be formed by a controlled amount of vertical etching to form openings to one or more contact sites, and then filling the openings with a conductor. Each contact 160, 162 may include any currently known or later developed conductive material configured for use in an electrical contact, e.g., tungsten (W). Contacts 160, 162 may additionally include refractory metal liners (not shown) positioned alongside ILD layer 178 to prevent electromigration degradation, shorting to other components, etc. Additionally, selected portions of n-type layer 156 and p-type layer 158 may include first and second silicide layers 172, 176 to increase the electrical conductivity at their physical interface with contact(s) 160, 162, where applicable. Silicide formation can include any now known or later developed silicidation process, e.g., annealing portions of layers 156, 158 in the presence of an overlying conductor (e.g., nickel, cobalt, titanium, etc.) to increase the electrical conductivity of layers 156, 158, and then removing any excess conductor.

It is understood that, in addition to a thickness T of gate metal layer 120, lateral distance X between terminals 150, 152 and, more accurately, contacts 160, 162 thereof, may also be user selected to determine required current and duration to program fuse 100. That is, a distance X between contacts 160, 162 can be controlled to control the current required to program fuse 100. Typically, a smaller distance X requires less current to program fuse 100.

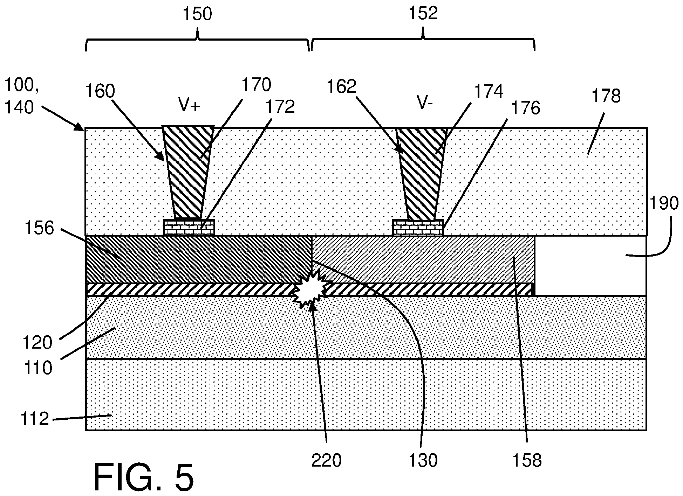

FIG. 5 shows a cross-sectional view of fuse 100 in a programmed condition. Programming fuse 100 occurs by reverse biasing PN junction 130, causing current to pass through fuse link 180 and open the fuse link. More particularly, programming of fuse 100 may occur by applying a higher voltage on first terminal 150 (V+) than second terminal 152 (V-), transmitting a current through first terminal 150, PN junction 130 and second terminal 152. Trench isolation 110 restrains current flow in gate metal layer 120. The diode formed by PN junction 130 in polysilicon layer 202 (FIG. 2) forces current through gate metal layer 120 when the diode is reversed biased. The current causes an opening 220 (e.g., opening or higher resistance area) through electromigration in fuse link 180 in gate metal layer 120, preventing or highly restricting further current from passing through fuse link 180. As shown in FIG. 5, in a programmed condition of fuse 100, e-fuse driver 190 has caused sufficient current to pass through fuse 100 such that electrical current between terminals 150, 152 is no longer possible because of the presence of opening 220.

Embodiments of the disclosure provide various technical and commercial advantages, examples of which are discussed herein. Fuse 100, including PN junction 130, enables precise programming of fuse 100 compared to conventional silicide-based e-fuses. Gate metal layer 120 has a thin and uniform thickness T that allows better dimension control of fuse link 180 to reduce fuse programming current variability compared to conventional silicide fuse links. Fuse 100 thus has improved e-fuse programming efficiency and production margins.

The structure and method as described above are used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher-level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

In the structures and method described above, a semiconductor material refers to a material whose conducting properties can be altered by doping with an impurity. Semiconductor materials include, for example, silicon-based semiconductor materials (e.g., silicon, silicon germanium, silicon germanium carbide, silicon carbide, etc.) and III-V compound semiconductors (i.e., compounds obtained by combining group III elements, such as aluminum (Al), gallium (Ga), or indium (In), with group V elements, such as nitrogen (N), phosphorous (P), arsenic (As) or antimony (Sb)) (e.g., GaN, InP, GaAs, or GaP). A pure semiconductor material and, more particularly, a semiconductor material that is not doped with an impurity for the purposes of increasing conductivity (i.e., an undoped semiconductor material) is referred to in the art as an intrinsic semiconductor. A semiconductor material that is doped with an impurity for the purposes of increasing conductivity (i.e., a doped semiconductor material) is referred to in the art as an extrinsic semiconductor and will be more conductive than an intrinsic semiconductor made of the same base material. That is, extrinsic silicon will be more conductive than intrinsic silicon; extrinsic silicon germanium will be more conductive than intrinsic silicon germanium; and so on. Furthermore, it should be understood that different impurities (i.e., different dopants) can be used to achieve different conductivity types (e.g., P-type conductivity and N-type conductivity) and that the dopants may vary depending upon the different semiconductor materials used. For example, a silicon-based semiconductor material (e.g., silicon, silicon germanium, etc.) is typically doped with a Group III dopant, such as boron (B) or indium (In), to achieve P-type conductivity, whereas a silicon-based semiconductor material is typically doped a Group V dopant, such as arsenic (As), phosphorus (P) or antimony (Sb), to achieve N-type conductivity. A gallium nitride (GaN)-based semiconductor material is typically doped with magnesium (Mg) to achieve P-type conductivity and with silicon (Si) or oxygen to achieve N-type conductivity. Those skilled in the art will also recognize that different conductivity levels will depend upon the relative concentration levels of the dopant(s) in a given semiconductor region. Furthermore, when a semiconductor region or layer is described as being at a higher conductivity level than another semiconductor region or layer, it is more conductive (less resistive) than the other semiconductor region or layer; whereas, when a semiconductor region or layer is described as being at a lower conductivity level than another semiconductor region or layer, it is less conductive (more resistive) than that other semiconductor region or layer.

The terminology used herein is for the purpose of describing particular embodiments only and is not intended to be limiting of the disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. "Optional" or "optionally" means that the subsequently described event or circumstance may or may not occur, and that the description includes instances where the event occurs and instances where it does not.

Approximating language, as used herein throughout the specification and claims, may be applied to modify any quantitative representation that could permissibly vary without resulting in a change in the basic function to which it is related. Accordingly, a value modified by a term or terms, such as "about", "approximately" and "substantially", are not to be limited to the precise value specified. In at least some instances, the approximating language may correspond to the precision of an instrument for measuring the value. Here and throughout the specification and claims, range limitations may be combined and/or interchanged, such ranges are identified and include all the sub-ranges contained therein unless context or language indicates otherwise. "Approximately" as applied to a particular value of a range applies to both values, and unless otherwise dependent on the precision of the instrument measuring the value, may indicate +/-10% of the stated value(s).

The corresponding structures, materials, acts, and equivalents of all means or step plus function elements in the claims below are intended to include any structure, material, or act for performing the function in combination with other claimed elements as specifically claimed. The description of the present disclosure has been presented for purposes of illustration and description, but is not intended to be exhaustive or limited to the disclosure in the form disclosed. Many modifications and variations will be apparent to those of ordinary skill in the art without departing from the scope and spirit of the disclosure. The embodiment was chosen and described in order to best explain the principles of the disclosure and the practical application, and to enable others of ordinary skill in the art to understand the disclosure for various embodiments with various modifications as are suited to the particular use contemplated.

In summary, the following embodiments are explicitly disclosed.
Embodiment 1: A one-time programmable (OTP) fuse, comprising:
   a trench isolation;
   a gate metal layer over the trench isolation; and
   a PN junction over the gate metal layer.
Embodiment 2: The OTP fuse of embodiment 1, wherein the PN junction is defined by a first terminal including a highly doped n-type polysilicon layer and a second terminal including a highly doped p-type polysilicon layer, wherein the highly doped n-type polysilicon layer contacts the highly doped p-type polysilicon layer.
Embodiment 3: The OTP fuse of embodiment 2, wherein the first terminal further includes a first contact over the highly doped n-type polysilicon layer, and the second terminal includes a second contact over the highly doped p-type polysilicon layer.
Embodiment 4: The OTP fuse of embodiment 3, wherein the first contact includes a first conductive body and a first silicide layer between the first conductive body and the highly doped n-type polysilicon layer, and the second contact includes a second conductive body and a second silicide layer between the second conductive body and the highly doped p-type polysilicon layer.
Embodiment 5: The OTP fuse of one of embodiments 2 to 4, wherein the OTP fuse is programmed by applying a higher voltage on the first terminal than the second terminal.
Embodiment 6: The OTP fuse of one of embodiments 1 to 5, wherein a fuse link is defined by a portion of the gate metal layer below the PN junction.
Embodiment 7: The OTP fuse of one of embodiments 1 to 6, wherein the gate metal layer is chosen from a group comprising: aluminum (Al), zinc (Zn), indium (In), tin (Sn), tantalum (Ta), tantalum nitride (TaN), tantalum carbide (TaC), titanium (Ti), titanium nitride (TiN), titanium carbide (TiC), titanium aluminum carbide (TiAlC), titanium aluminum (TiAl), tungsten (W), tungsten nitride (WN), and tungsten carbide (WC).
Embodiment 8: The OTP fuse of one of embodiments 1 to 7, wherein the gate metal layer has a uniform thickness along a length thereof.
Embodiment 9: The OTP fuse of one of embodiments 1 to 8, further comprising an e-fuse driver adjacent the gate metal layer.
Embodiment 10: The OTP fuse of one of embodiments 1 to 9,
   wherein the trench isolation is formed in a substrate,
   wherein the PN junction is created by a first terminal including a highly doped n-type polysilicon layer over the trench isolation and a second terminal including a highly doped p-type polysilicon layer over the trench isolation, the highly doped n-type polysilicon layer contacting the highly doped p-type polysilicon layer, and
   wherein the OTP fuse further comprises a fuse link defined in a portion of the gate metal layer between the trench isolation and the PN junction.
Embodiment 11 A one-time programmable (OTP) fuse, comprising:
   a trench isolation in a substrate;
   a first terminal including a highly doped n-type polysilicon layer over the trench isolation;
   a second terminal including a highly doped p-type polysilicon layer over the trench isolation,
   wherein the highly doped n-type polysilicon layer contacts the highly doped p-type polysilicon layer, creating a PN junction; and
   a fuse link defined in a portion of a gate metal layer between the trench isolation and the PN junction.
Embodiment 12: The OTP fuse of embodiment 10 or 11, wherein the first terminal further includes a first contact over the highly doped n-type polysilicon layer, and the second terminal includes a second contact over the highly doped p-type polysilicon layer.
Embodiment 13: The OTP fuse of embodiment 12, wherein the first contact includes a first conductive body and a first silicide layer between the first conductive body and the highly doped n-type polysilicon layer, and the second contact includes a second conductive body and a second silicide layer between the second conductive body and the highly doped p-type polysilicon layer.
Embodiment 14: The OTP fuse of one of embodiments 10 to 13, wherein the gate metal layer has a uniform thickness along a length thereof.
Embodiment 15: The OTP fuse of one of embodiments 10 to 14, wherein the gate metal layer is chosen from a group comprising: aluminum (Al), zinc (Zn), indium (In), tin (Sn), tantalum (Ta), tantalum nitride (TaN), tantalum carbide (TaC), titanium (Ti), titanium nitride (TiN), titanium carbide (TiC), TiAlC, TiAl, tungsten (W), tungsten nitride (WN), and tungsten carbide (WC).
Embodiment 16: The OTP fuse of one of embodiments 10 to 15, further comprising an e-fuse driver adjacent the gate metal layer.
Embodiment 17: The OTP fuse of one of embodiments 10 to 16, wherein the OTP fuse is programmed by applying a higher voltage on the first terminal than the second terminal.
Embodiment 18: A method of forming a one-time programmable (OTP) fuse, the method comprising:
   forming a gate metal stack including a trench isolation over a substrate, a gate metal layer over the trench isolation and a polysilicon layer over the trench isolation;
   forming a first terminal by doping a first portion of the polysilicon layer with an n-type dopant, creating a highly doped n-type polysilicon layer over the gate metal layer; and
   forming a second terminal by doping a second portion of the polysilicon layer with a p-type dopant, creating a highly doped p-type polysilicon layer over the gate metal layer,
   wherein the highly doped n-type polysilicon layer contacts the highly doped p-type polysilicon layer, creating a PN junction and a fuse link in the gate metal layer under the PN junction.
Embodiment 19: The method of embodiment 18, wherein forming the first terminal further includes forming a first contact over the highly doped n-type polysilicon layer, and forming the second terminal further includes forming a second contact over the highly doped p-type polysilicon layer.
Embodiment 20: The method of embodiment 19, wherein the first contact includes a first conductive body and a first silicide layer between the first conductive body and the highly doped n-type polysilicon layer, and the second contact includes a second conductive body and a second silicide layer between the second conductive body and the highly doped p-type polysilicon layer.
Embodiment 21: The method of one of embodiments 18 to 20, further comprising programming the OTP fuse by reverse biasing the PN junction, causing current to pass through the fuse link and open the fuse link.
Embodiment 22: The method of one of embodiments 18 to 21, wherein the OTP fuse of one of embodiments 1 to 17 is formed.

At least in the embodiments above, the term "include" and its variants may be interpreted as meaning that an embodiment includes stated features, while not necessarily excluding the presence of other features that are not explicitly stated.

A reference to an orientation indicated by "horizontal" in the above described embodiments may be understood as being parallel to a main surface of a layer, e.g., a surface of a layer on which another surface is formed or provided in case of a layer stack. In other words, horizontal may be understood as being perpendicular to a normal of a main surface of a layer such as an upper or a lower surface of a first layer in a layer stack (at least two layers in the stack) interfacing another main surface of a second layer formed on the first layer. In some non-limiting examples, a "lateral" direction may be understood as being an in-plane direction, e.g., a horizontal direction when considering a virtual plane given by an interface plane or a main surface of a layer in a layer stack. For example, the PN junction may be at least part of a layer stack in this respect.

## Claims

1. A one-time programmable (OTP) fuse, comprising:
a trench isolation;
a gate metal layer over the trench isolation; and
a PN junction over the gate metal layer.

2. The OTP fuse of claim 1, wherein the PN junction is defined by a first terminal including a highly doped n-type polysilicon layer and a second terminal including a highly doped p-type polysilicon layer, wherein the highly doped n-type polysilicon layer contacts the highly doped p-type polysilicon layer, the OTP fuse preferably being programmed by applying a higher voltage on the first terminal than the second terminal.

3. The OTP fuse of claim 2, wherein the first terminal further includes a first contact over the highly doped n-type polysilicon layer, and the second terminal includes a second contact over the highly doped p-type polysilicon layer.

4. The OTP fuse of claim 3, wherein the first contact includes a first conductive body and a first silicide layer between the first conductive body and the highly doped n-type polysilicon layer, and the second contact includes a second conductive body and a second silicide layer between the second conductive body and the highly doped p-type polysilicon layer.

5. The OTP fuse of one of claims 1 to 4, wherein:
a fuse link is defined by a portion of the gate metal layer below the PN junction; and/or
the gate metal layer has a uniform thickness along a length thereof; and/or
the OTP fuse further comprises an e-fuse driver adjacent the gate metal layer.

6. The OTP fuse of one of claims 1 to 5, wherein the gate metal layer is chosen from a group comprising: aluminum (Al), zinc (Zn), indium (In), tin (Sn), tantalum (Ta), tantalum nitride (TaN), tantalum carbide (TaC), titanium (Ti), titanium nitride (TiN), titanium carbide (TiC), titanium aluminum carbide (TiAlC), titanium aluminum (TiAl), tungsten (W), tungsten nitride (WN), and tungsten carbide (WC).

7. A one-time programmable (OTP) fuse, comprising:
a trench isolation in a substrate;
a first terminal including a highly doped n-type polysilicon layer over the trench isolation;
a second terminal including a highly doped p-type polysilicon layer over the trench isolation, wherein the highly doped n-type polysilicon layer contacts the highly doped p-type polysilicon layer, creating a PN junction; and
a fuse link defined in a portion of a gate metal layer between the trench isolation and the PN junction.

8. The OTP fuse of claim 7, wherein the first terminal further includes a first contact over the highly doped n-type polysilicon layer, and the second terminal includes a second contact over the highly doped p-type polysilicon layer.

9. The OTP fuse of claim 8, wherein the first contact includes a first conductive body and a first silicide layer between the first conductive body and the highly doped n-type polysilicon layer, and the second contact includes a second conductive body and a second silicide layer between the second conductive body and the highly doped p-type polysilicon layer.

10. The OTP fuse of one of claims 7 to 9, wherein:
the gate metal layer has a uniform thickness along a length thereof; and/or
the gate metal layer is chosen from a group comprising: aluminum (Al), zinc (Zn), indium (In), tin (Sn), tantalum (Ta), tantalum nitride (TaN), tantalum carbide (TaC), titanium (Ti), titanium nitride (TiN), titanium carbide (TiC), TiAlC, TiAl, tungsten (W), tungsten nitride (WN), and tungsten carbide (WC); and/or
the OTP fuse is programmed by applying a higher voltage on the first terminal than the second terminal.

11. The OTP fuse of one of claims 7 to 10, further comprising an e-fuse driver adjacent the gate metal layer.

12. A method of forming a one-time programmable (OTP) fuse, the method comprising:
forming a gate metal stack including a trench isolation over a substrate, a gate metal layer over the trench isolation and a polysilicon layer over the trench isolation;
forming a first terminal by doping a first portion of the polysilicon layer with an n-type dopant, creating a highly doped n-type polysilicon layer over the gate metal layer; and
forming a second terminal by doping a second portion of the polysilicon layer with a p-type dopant, creating a highly doped p-type polysilicon layer over the gate metal layer,
wherein the highly doped n-type polysilicon layer contacts the highly doped p-type polysilicon layer, creating a PN junction and a fuse link in the gate metal layer under the PN junction.

13. The method of claim 12, wherein forming the first terminal further includes forming a first contact over the highly doped n-type polysilicon layer, and forming the second terminal further includes forming a second contact over the highly doped p-type polysilicon layer.

14. The method of claim 13, wherein the first contact includes a first conductive body and a first silicide layer between the first conductive body and the highly doped n-type polysilicon layer, and the second contact includes a second conductive body and a second silicide layer between the second conductive body and the highly doped p-type polysilicon layer.

15. The method of one of claims 12 to 14, further comprising programming the OTP fuse by reverse biasing the PN junction, causing current to pass through the fuse link and open the fuse link.
